# EUROPEAN PATENT SPECIFICATION

(11) **EP 3 196 339 B1**
(45) Date of publication and mention of the grant of the patent: **28.08.2019**
(21) Application number: 15842761.7
(22) Date of filing: 14.09.2015
(51) Int. Cl.: C23C 18/40, H05K 3/10, H05K 3/18, H05K 3/40, C23C 18/16, H05K 3/42

(54) **METHOD FOR MANUFACTURING WIRING SUBSTRATE**
VERFAHREN ZUR HERSTELLUNG EINES VERDRAHTUNGSSUBSTRATES
PROCÉDÉ DE FABRICATION D'UN SUBSTRAT DE CÂBLAGE

(30) Priority: 17.09.2014 JP 2014188896
(43) Date of publication of application: 26.07.2017
(73) Proprietor: C. Uyemura & Co., Ltd., Osaka-shi, Osaka 541-0045 (JP)
(72) Inventor: YAMAMOTO, Hisamitsu, Hirakata-shi Osaka 573-0065 (JP); KAWASE, Tomohiro, Hirakata-shi Osaka 573-0065 (JP); TAKEUCHI, Masaharu, Hirakata-shi Osaka 573-0065 (JP)
(74) Representative: Delorme, Nicolas
(86) International application number: PCT/JP2015/004679
(87) International publication number: WO 2016/042754

(56) References cited:
- WO-A1-2014/091662
- JP-A- 2010 031 361
- JP-A- 2011 173 063
- JP-A- 2011 173 063
- JP-B2- 2 978 780
- JP-B2- 3 091 583
- US-A- 4 525 390
- US-A- 4 684 545
- US-A- 4 865 888
- US-A1- 2010 003 399
- US-A1- 2013 122 704

## Description

### TECHNICAL FIELD

The present invention relates to a method for fabricating a wiring board, and more particularly relates to a method for fabricating a wiring board with deposition of an excessive plating metal that has overflowed out of trenches reduced significantly.

### BACKGROUND ART

Breakthroughs in electronics industries have created a rapidly increasing demand for printed wiring boards with even higher densities and further enhanced performances. Among other things, a recent dramatic reduction in the size or thickness of cellphones, laptops, cameras, and other latest digital devices has created a surging demand for further increasing the density, and further decreasing the size, of wiring patterns for their motherboards. In addition, it has become more and more necessary to connect together multiple components on a printed wiring board at radio frequencies, thus making a highly reliable wiring board adapted to process radio frequency signals a highly sought-after commodity.

Meanwhile, methods for fabricating a wiring board by either a semi-additive process or a full-additive process are currently adopted as circuit implementation techniques.

In general, according to the semi-additive process which is a build-up process, the surface of a substrate is subjected to an electroless copper plating process, for example, to form an undercoat thereon, a circuit pattern is formed thereon with photoresist, and then a copper circuit is formed through an electroplating process of copper. According to the semi-additive process, however, a current may flow differently during the electroplating process depending on the density of the copper circuit formed, the shape of the substrate, or any other factor, thus causing a variation in the thickness of the plating (i.e., the height of the copper circuit), which is not beneficial. In addition, as the size of the circuit is reduced (e.g., as the width of the wiring itself or the space between adjacent portions of the wiring is narrowed), misalignment or development failure is more and more likely to occur while a photoresist pattern is being formed, thus resulting in frequent occurrence of disconnections and/or short circuits. Moreover, according to the semi-additive process, the metal copper formed by an electroless plating process as an undercoat to make electrically conductive the copper plating to be deposited by electroplating of copper needs to be etched away after the electroplating process of copper is finished. This etching process could cause essential circuit sections to be disconnected unintentionally, or could also cause a circuit to be short-circuited if the metal copper was etched insufficiently.

On the other hand, according to the full-additive process, a catalyst is applied onto a base member with blind vias, a circuit pattern is formed thereon after that with a photoresist, and then a copper circuit is formed by only electroless copper plating process. According to the conventional full-additive process, however, the smaller the size of the circuit is, the more frequently misalignment, development failure, and other inconveniences will occur while a photoresist pattern is being formed, thus resulting in disconnections and short-circuits more and more often. In addition, this process is so designed as to allow the catalyst to remain under the photoresist. However, as the size of the circuit is reduced, the residual catalyst is more and more likely to decrease the degree of electrical insulation between the circuits to the point of causing short-circuit between them.

Thus, to overcome these problems with the conventional circuit implementation techniques, someone proposed a process in which trenches and/or via holes are laser-cut on or through the surface of a substrate and then subjected to an electroless copper plating process.

More specifically, a method for fabricating a wiring board has been disclosed in which the surface of a substrate with a fine-line pattern is plated with an electroless copper plating solution including copper ions and a complexing agent and reducing agent thereof and in which air bubbles of an oxygen-containing gas are dispersed in the plating solution. They say that such a method allows the plating reaction to stop much less often and may prevent the plating solution from being deposited abnormally (sec, for example, Patent Document 1).

Meanwhile, according to another method disclosed, an air bubble flow comprised of a huge number of air bubbles is supplied to a printed wiring board in an electroless plating tank from under the board, while the plating solution is allowed to circulate from an overflow dam provided for the plating tank into an external circulation channel. Air is blown into a circulation channel leading from the external circulation channel back to the plating tank, thereby producing very small air bubbles and increasing the concentration of oxygen dissolved in the plating solution in the electroless plating tank. They argue that according to such a method, a plating coating formed on the printed wiring board may be stretched so well, and the frequency of occurrence of nodules may be decreased so significantly, that the electroless copper plating process may be carried out as intended (sec, for example, Patent Document 2).

WO 2014/0921662 A1 discloses a production method for a printed wiring board, which includes the steps of :
- forming a second resin layer covering a conductor circuit on a first resin layer,
- forming a water-repellent protective layer on the surface of the second resin layer,
- cutting a via hole and a trench through/in the second resin layer via a through hole of the protective layer,
- applying a catalyst to the second resin layer to allow the catalyst to adhere to the via hole and the trench,
- stripping the protective layer formed on the surface of the second resin layer, and
- filling the via hole and the trench, to each of which the catalyst has adhered, with a plating metal by electroless plating.

US 2010/003399 A1 discloses an electroless plating solution exhibiting a good plating metal filling performance. The electroless plating solution contains at least a water-soluble metal salt, a reducing agent for reducing metal ions derived from the water-soluble metal salt, and a chelating agent. In addition, the electroless plating solution contains a sulfur-based organic compound as a leveler having at least one aliphatic cyclic group or aromatic cyclic group to which may be linked at least one optional substituent.

US 4 865 888 A discloses an electroless copper plating process for producing fine patterned wiring boards which is improved by supplying very fine oxygen-containing gas bubbles through a porous alkali-resistant resin gas dispersing tube.

US 4 525 390 A discloses a process for plating copper onto a substrate from electroless plating compositions, which comprises :
- plating a first layer of copper onto said substrate from a first alkaline electroless copper plating bath containing about 4 to 7 ppm of cyanide ions and an oxygen content of 1.5 ppm or less;
- plating a second layer of copper onto said first layer of copper from a second alkaline electroless copper plating bath containing about 8 to 10 ppm of cyanide ion and an oxygen content of about 2.5 to 4 ppm; and
wherein values of the oxygen content are for baths at a temperature of about 70°C to 80°C.

### CITATION LIST

### PATENT DOCUMENT

PATENT DOCUMENT 1: Japanese Unexamined Patent Publication No. H07-154056
PATENT DOCUMENT 2: Japanese Unexamined Patent Publication No. H06-97632

### SUMMARY OF INVENTION

### TECHNICAL PROBLEM

According to the method disclosed in Patent Document 1, however, the air bubbles in the plating solution would converge toward the outlet of the circulation system, and have a size of as large as 10 mm. In addition, while rising through the liquid, those bubbles would combine together to form bubbles of an even larger size. As a result, those bubbles would no longer be dispersed uniformly. Thus, the bubbles could not cover the entire surface of the substrate uniformly, which would allow the plating solution to be deposited outside of the trenches or via holes of the printed wiring board and cause the circuits to be short-circuited.

Also, according to the method disclosed in Patent Document 2, the air bubbles produced have a size of as large as 0.5 mm, and the plating solution flows just slowly in the plating tank. Thus, those air bubbles would contact with each other in an upper portion of the plating tank, and would not be distributed uniformly over the entire surface of the substrate. As a result, the plating would be deposited outside of the trenches or via holes of the printed wiring board to cause the circuits to be short-circuited.

In view of the foregoing background, it is therefore an object of the present invention to provide a method for fabricating a wiring board with deposition of an excessive plated metal that has overflowed out of trenches or via holes reduced significantly.

### SOLUTION TO THE PROBLEM

To achieve this object, the present invention provides a method for fabricating a wiring board according to claim 1 in which a target substrate having via holes and/or trenches is subjected to an electroless plating process while being immersed in an electroless plating solution to fill the via holes and/or the trenches with a plating metal.

The electroless plating solution includes at least a water-soluble metal salt, a reducing agent, and a complexing agent, and also includes a leveler comprised of at least one sulfur-containing organic compound represented by any one of the following general Formulae (I)-(V):

R¹-(S)ₙ-R² (I)

R¹-L¹-(S)ₙ-R² (II)

R¹-L¹-(S)ₙ-L²-R² (III)

R¹-(S)ₙ-L³ (IV)

R¹-L¹-(S)ₙ-L³ (V)

where n is an integer equal to or greater than one; R¹ and R² independently represent an aliphatic or aromatic cyclic group including any arbitrary number of carbon atoms, oxygen atoms, phosphorus atoms, sulfur atoms, or nitrogen atoms, or a cyclic group in which one or more arbitrary substituents are bonded to the aliphatic or aromatic cyclic group;
L¹ and L² independently represent a linear or branched one of a chain selected from the group consisting of an alkyl chain, an alkyl amino chain, an alkylene chain, and an alkoxy chain, and
L³ is selected from the group consisting of an alkyl group, an alkylene group, an amino group, an alkyl amino group, an alkylene amino group, a hydroxyl group, an alkyl hydroxyl group, an alkylene hydroxyl group, a carboxyl group, an alkyl carboxyl group, an alkylene carboxyl group, an alkyl amino carboxyl group, an alkylene amino carboxyl group, a nitro group, an alkyl nitro group, a nitrile group, an alkyl nitrile group, an amide group, an alkyl amide group, a carbonyl group, an alkyl carbonyl group, a sulfonic group, an alkyl sulfonic group, a phosphonic group, an alkyl phosphonic group, a sulfanyl group, a sulfinyl group, and a thiocarbonyl group.

According to this configuration, a more rapid rising liquid current of the plating solution produced inside the plating bath allows air bubbles in the plating solution to be uniformly dispersed over the entire surface of the target substrate, which results in an increase in the concentration of oxygen dissolved on the surface of the target substrate. This produces an oxidizing atmosphere inside the plating bath, thus preventing the plating solution from being deposited anomalously outside of the trenches or via holes of the target substrate. Consequently, disconnection and short circuit of the conductor circuit on the wiring board, which would otherwise be caused by the anomalous deposition of the excess of the plated metal, and other inconveniences may be reduced significantly.

### ADVANTAGES OF THE INVENTION

The present invention may reduce the occurrence of disconnection, conductor circuit short-circuit, and other inconveniences resulting from anomalous deposition of a plating metal.

### BRIEF DESCRIPTION OF THE DRAWINGS

[FIG. 1] A cross-sectional view illustrating a printed wiring board fabricated according to a first embodiment of the present invention.
[FIG. 2] Illustrates an electroless plating system used in the first embodiment of the present invention.
[FIG. 3] Cross-sectional views illustrating respective manufacturing process steps of the method to fabricate a printed wiring board according to the first embodiment of the present invention.
[FIG. 4] Cross-sectional views illustrating respective manufacturing process steps of the method to fabricate a printed wiring board according to the first embodiment of the present invention.
[FIG. 5] Illustrates an electroless plating system used in a second embodiment of the present invention.
[FIG. 6] A metallographic micrograph of a wiring board fabricated by a method according to a first specific example.
[FIG. 7] A metallographic micrograph of a wiring board fabricated by a method according to a second comparative example.

### DESCRIPTION OF EMBODIMENTS

Embodiments of the present invention will now be described in detail with reference to the drawings. Note that the present invention is in no way limited to the following exemplary embodiments.

### (First Embodiment)

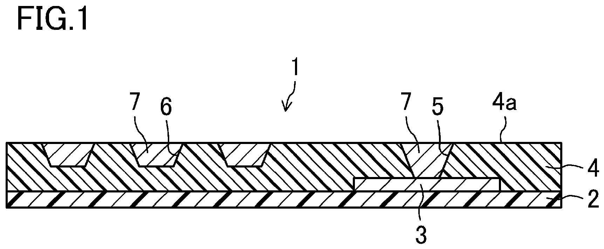

FIG. 1 is a cross-sectional view illustrating a printed wiring board fabricated according to a first embodiment of the present invention.

As shown in FIG. 1, the printed wiring board 1 fabricated in this embodiment includes: a first resin layer 2; a conductor circuit 3 provided on the first resin layer 2; a second resin layer 4 deposited over the first resin layer 2 to cover the conductor circuit 3; via holes 5 and trenches 6 cut through/on the second resin layer 4; and a metal layer 7 filling those via holes 5 and trenches 6.

The first resin layer 2 functions as a base substrate for the printed wiring board 1, and is made of an electrically insulating resin material. Examples of the resin material for the first resin layer 2 include an epoxy resin, a polyimide resin, a bismaleimide-triazine resin, a polyphenylene ether resin, a liquid crystal polymer, a polyether ether ketone resin, a polyether imide resin, and a polyether sulfone resin.

Optionally, a plate member of a resin-resin composite material in which a three-dimensional mesh of a fluorine resin base material such as a continuous porous polytetrafluoroethylene resin is impregnated with a thermosetting resin such as an epoxy resin may also be used, for example.

The conductor circuit 3 is a metallized circuit forming a wiring pattern for the printed wiring board 1, and may have been either adhered onto, or plated on, the first resin layer 2.

The conductor circuit 3 may be formed out of either foil of a metal such as copper, aluminum, iron, nickel, chromium, or molybdenum or foil of an alloy thereof (e.g., a copper alloy such as an aluminum bronze alloy, a phosphorus bronze alloy, or a yellow bronze alloy, stainless steel, umber, a nickel alloy, or a tin alloy).

The conductor circuit 3 may be either a single layer of foil of any one of these metals or a stack of multiple layers of foil of any two or more metals selected from this group. To improve the adhesion and conductivity of the plating and cut down the cost, copper or an alloy thereof is used beneficially.

The second resin layer 4 plays the role of protecting the conductor circuit 3 on the surface of the first resin layer 2. The material for this second resin layer 4 may be the same as the material for the first resin layer 2.

Among other things, an epoxy resin is suitably used as a material for the first and second resin layers 2, 4 for the following reasons. First of all, an epoxy resin is highly resistant to an electroless plating process (e.g., allows no toxic substances to elute when exposed to the plating solution or no interfacial peeling to occur). In addition, an epoxy resin would allow no peeling or cracking to occur during a cold cycle test, for example, by increasing the degree of adhesion between the material itself and the conductor circuit 3 and between the first and second resin layers 2, 4.

The metal layer 7 may be formed by filling the via holes 5 and trenches 6 with a plating metal through a plating process (such as an electroless plating process). Examples of a metal to make this metal layer 7 include copper and nickel.

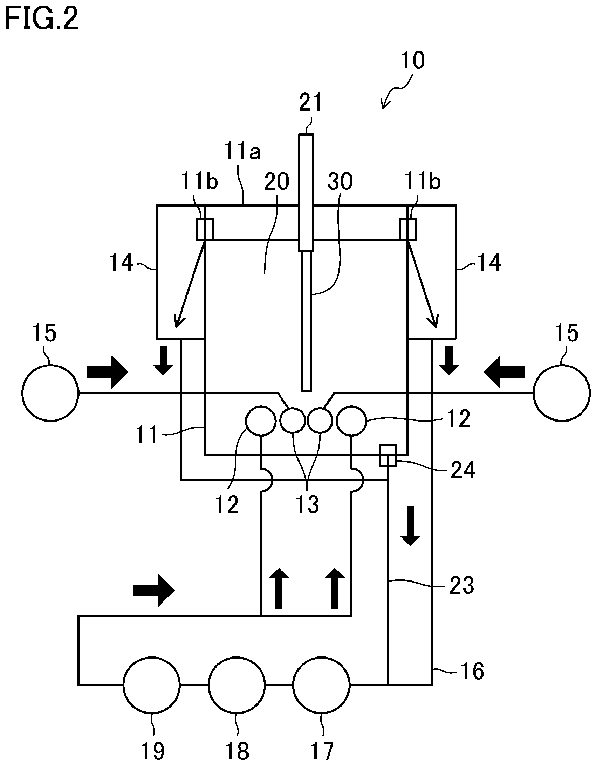

Next, an electroless plating system used in this embodiment will be described with reference to the drawings. FIG. 2 illustrates an electroless plating system used in a first embodiment of the present invention.

This electroless plating system 10 is designed to fill the via holes 5 and trenches 6 with a plating metal by subjecting a given substrate to a plating process (such as an electroless plating process) and thereby form a metal layer 7 to be the circuitry of the printed wiring board 1.

This electroless plating system 10 includes: a plating tank 11 filled with a plating solution 20; a plating solution supply means 12 for supplying the plating solution 20 into the plating tank 11; a diffusion means 13 for diffusing an oxygen-containing gas (i.e., air bubbles) into the plating solution 20 under a target substrate 30 in the plating tank 11; and an overflow tank 14 for reserving the plating solution 20 that has overflowed out of the plating tank 11.

The plating tank 11 is a generally rectangular parallelepiped container with a substantially rectangular opening 11a at the top, and is filled with the plating solution 20. Also, as shown in FIG. 2, the plating tank 11 is configured to immerse the target substrate 30 in its entirety in the plating solution 20 that fills the plating tank 11 when a plating process is carried out.

Furthermore, as shown in FIG. 2, this system is configured such that the target substrate 30 is immersed in its entirety in the plating solution 20 while being held by a jig 21 arranged over the plating tank 11.

This jig 21 includes a frame larger in dimensions than the target substrate 30, and a clamp provided for the top and bottom sides of the frame to grip the target substrate 30 at its ends. The jig 21 is connected to a transporter (not shown) which is movable both vertically and horizontally.

Also, the target substrate 30 is immersed substantially perpendicularly into the plating solution 20, and is gripped such that the surface of the target substrate 30 is substantially parallel to the wall surfaces of the plating tank 11.

The liquid supply means 12 is arranged below the target substrate 30 in the plating tank 11. This liquid supply means 12 may be comprised of two tubular members, which have a plurality of liquid ejection holes, are arranged horizontally to each other, have a greater overall length than the horizontal width of the target substrate 30, and are arranged at an equal distance from the target substrate 30. Thus, these two tubular members may enhance the effect of the liquid current on both of the top and back surfaces of the target substrate 30.

The diffusion means 13 is arranged under the target substrate 30 in the plating tank 11. As shown in FIG. 2, this diffusion means 13 is arranged adjacent to the liquid supply means 12 and connected to an air pump 15 for supplying an oxygen-containing gas to the diffusion means 13.

This diffusion means 13 may be comprised of two tubular members made of a porous ceramic material, for example. These two tubular members are arranged horizontally to each other, provided at an equal distance from the target substrate 30, and configured to supply the oxygen-containing gas onto the surface of the target substrate 30 at a sufficiently high rate. This diffusion means 13 is also configured such that the oxygen-containing gas, supplied from the air pump 15 into the diffusion means 13, is diffused into the plating solution 20 via a porous body made of a porous ceramic material.

The diffusion means is exposed to a gas pressure for a long time. Thus, diffusion means made of a resin such as a fluorine resin could be damaged in the plating solution. In this embodiment, however, the diffusion means is made of a porous ceramic material with higher hardness and abrasion resistance than a fluorine resin, and therefore, would not be damaged in the plating solution 20. In addition, the diffusion means 13 may also be recyclable by cleaning off dirt, if any, deposited onto the pores of the porous body.

Furthermore, the oxygen-containing gas suitably has an air bubble size of 5 to 50 µm in order to prevent the air bubbles from entering the trenches 6 or via holes 5 and to increase the concentration of oxygen dissolved in the plating solution 20.

Moreover, in the present invention the diffusion process by the diffusion means 13 is temporarily suspended for a predetermined amount of time (of, e.g., 1 to 2 minutes) before the electroless plating process is started (i.e., before the target substrate 30 is completely immersed in the plating solution 20) in order to prevent the plating solution 20 from being decomposed due to the progress of the reduction reaction and to initiate the plating deposition reaction with reliability in the trenches 6 and via holes 5.

Besides, the oxygen-containing gas is suitably supplied into the plating solution 20 at a rate of 0.1 to 1.0 L/min (per liter of the plating solution) in order to reliably prevent the concentration of oxygen dissolved in the plating solution 20 from increasing more than expected to reduce the deposition of the plating solution inside the trenches 6 and the via holes 5 or decreasing more than expected to allow the plating solution to be deposited outside of the trenches 6 and via holes 5.

The overflow tank 14 is arranged adjacent to the plating tank 11 and disposed on both sides at the top of the plating tank 11 which face each other with the opening 11a interposed between them (i.e., at the top of two opposing ones of the four sidewalls of the plating tank 11 having a generally rectangular shape in a plan view).

This plating system is configured to allow the plating solution 20 filling the plating tank 11 to overflow into, and be reserved in, the overflow tank 14 through outlets 11b of the plating tank 11.

Furthermore, as shown in FIG. 2, this electroless plating system 10 further includes: a circulation passage 16 connected to the plating tank 11 and the overflow tank 14 to allow the plating solution reserved in the overflow tank 14 to flow back into the plating tank 11; and a pump 17, a temperature adjustment means 18, and a filter 19 which are provided on the circulation passage 16.

The plating solution 20 reserved in the overflow tank 14 is guided by the pump 17 toward the circulation passage 16, has its temperature adjusted by the temperature adjustment means 18, has foreign substances filtered out by the filter 19, and then circulates through the circulation passage 16 to flow back into the plating tank 11. This system is configured to produce a rapidly rising liquid current of the plating solution 20 inside the plating tank 11 (i.e., a rapid liquid current rising from the bottom toward the top of the plating tank 11).

The plating tank 11 has a discharge port 24 at the bottom. The plating solution 20 discharged through the discharge port 24 is guided toward the circulation passage 16 through a discharge passage 23 connected to the circulation passage 16. Thereafter, just like the plating solution 20 reserved in the overflow tank 14, the plating solution 20 has its temperature adjusted by the temperature adjustment means 18, has foreign substances filtered out by the filter 19, and then circulates through the circulation passage 16 to flow back into the plating tank 11. This configuration allows the foreign substances accumulated at the bottom of the plating tank 11 to be filtered out.

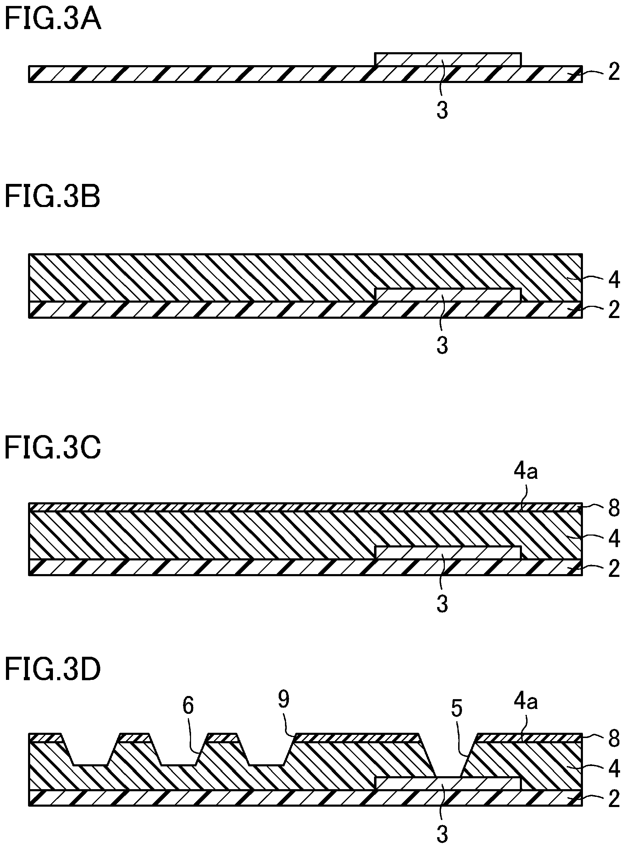

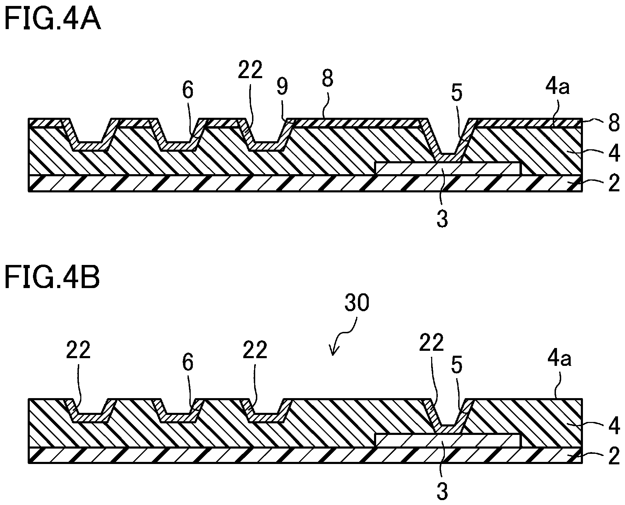

Next, an exemplary method for fabricating a printed wiring board according to this embodiment will be described. FIGS. 3 and 4 are cross-sectional views illustrating respective manufacturing process steps of a method to fabricate a printed wiring board according to the first embodiment of the present invention. The manufacturing process of this embodiment includes a conductor circuit forming process step, a second resin layer forming process step, a protective layer forming process step, a via hole/trench forming process step, a plating pretreatment process step, a catalyst applying process step, a protective layer stripping process step, and a plating process step.

### <Conductor Circuit Forming Process Step>

First of all, a sheet of copper foil (with a thickness of a few µm to 25 µm) is adhered onto the surface of a first resin layer 2 of an epoxy resin, for example, thereby forming a copper-clad laminate on the surface of the first resin layer 2. Next, this copper-clad laminate is patterned by photolithography, screen printing, or any other appropriate technique to form a conductor circuit 3 on the surface of the first resin layer 2 as shown in FIG. 3(a).

Alternatively, the copper-clad laminate may also be formed by plating the first resin layer 2 with copper foil.

### <Second Resin Layer Forming Process Step>

Next, an epoxy resin, for example, is deposited (to a thickness of 20 µm to 100 µm) over the first resin layer 2 to cover the conductor circuit 3, and then subjected to a heating and pressurizing process (e.g., heated to a temperature of 100 to 300°C and exposed to a pressure of 5 to 60 kg/cm²), thereby forming a second resin layer 4 of the epoxy resin over the first resin layer 2 to cover the conductor circuit 3 as shown in FIG. 3(b).

Optionally, the second resin layer 4 may also be bonded and stacked onto the first resin layer 2 with an adhesive layer (not shown).

### <Protective Layer Forming Process Step>

Subsequently, a polyimide resin, for example, is applied (to a thickness of 0.1 µm to 10 µm) onto the second resin layer 4 and then heated, thereby forming a protective layer 8 of the polyimide resin over the second resin layer 4 as shown in FIG. 3(c).

Optionally, before the protective layer 8 is stacked over the second resin layer 4, an adhesive layer (not shown) may be formed first over the second resin layer 4. After that, the protective layer 8 may be stacked over the second resin layer 4 with the adhesive layer interposed between them. In that case, a heat-resistant adhesive sheet of a polyamide resin, a polyester resin, a polyolefin resin, or a polyurethane resin, for example, may be used as to make the adhesive layer, and melted under heat to form the adhesive layer. The adhesive layer may be melted under any condition, which may be changed appropriately depending on the type of the resin that makes the adhesive sheet. For example, the adhesive sheet may be melted by being heated to a temperature of about 100-190°C for 30 seconds to 2 minutes to form the adhesive layer.

This protective layer 8 is provided to allow the catalyst to be selectively applied onto only the via holes 5 and trenches 6 of the second resin layer 4, and prevent the catalyst from being deposited onto the surface 4a of the second resin layer 4 (see FIGS. 1 and 3(c)) in the catalyst applying process step to be described later.

Also, this protective layer 8 is made of a resin which has electrical insulation and water repellent properties and which is dissolvable in a stripping agent for use in the protective layer stripping process step to be described later. Examples of the resin that makes the protective layer 8 include alkali soluble resins such as a polyimide resin, a silicon resin, a phenol resin, a xylene resin, an unsaturated polyester resin, a diallyl phthalate resin, an acrylic resin, and a polycarbonate resin, and alcohol soluble resins such as an acrylic resin, a phenol resin, an ABS resin, and a polyisobutylene resin.

The protective layer 8 suitably has a thickness of 0.1 µm to 10 µm for the following reasons. Specifically, a protective layer 8 with a thickness of less than 0.1 µm could be too thin to maintain its intended function of allowing the catalyst to be applied onto only the via holes 5 and trenches 6 and preventing the catalyst from being applied onto the surface 4a of the second resin layer 4 in the catalyst applying process step to be described later. Also, a protective layer 8 with a thickness of more than 10 µm would have trenches 6, of which the depth would have been increased too much to form the trenches 6 easily on a printed wiring board 1 with a narrow trench width.

### <Via Hole/Trench Forming Process Step>

Thereafter, as shown in FIG. 3(d), through holes 9 are cut through the protective layer 8 on the second resin layer 4, and then via holes 5 and trenches 6 are cut through these through holes 9 on the second resin layer 4 covered with the protective layer 8.

The method of forming these via holes 5, trenches 6, and through holes 9 is not particularly limited. For example, these holes may be formed by etching or laser cutting. Among other things, the via holes 5 and other holes are suitably formed by laser cutting, in particular, in order to quickly form via holes 5 and other holes in a minute shape, to avoid various inconveniences such as misalignment and development failure due to errors occurring in exposure or development during the etching process, and to form a wiring pattern that is reliable enough to meet growing demands for wiring boards of reduced sizes, thicknesses, and overall dimensions.

Also, when the via holes 5 and other holes are cut by this laser cutting, the laser used may be a general one such as a CO₂ laser, a YAG laser, or an excimer laser. Alternatively, a gas laser such as an argon laser or a helium-neon laser, a solid-state laser such as a sapphire laser, a dye laser, a semiconductor laser, a free electron laser, or any other appropriate type of laser may also be used. Among other things, a general laser such as a YAG laser or an excimer laser is suitably used from the standpoint of cutting via holes 5 in even minute shapes.

The aspect ratios, diameters, depths and other parameters of the via holes 5 and trenches 6 may be appropriately adjusted according to the type of the printed wiring board 1, for example. Specifically, the via holes 5 may have a diameter of 10-200 µm and a depth of 2-20 µm, for example, and the trenches 6 may have a width of 1-500 µm and a depth of 2-20 µm, for instance.

### <Plating Pretreatment Process Step>

Next, the substrate with those via holes 5 and trenches 6 is subjected to a predetermined plating pretreatment. More specifically, for example, the substrate is immersed in a cleaning solution (such as an acidic solution or a neutral solution) at 65°C for 5 minutes, thereby cleaning off dirt and other unnecessary substances from the surface of the substrate, the via holes 5, and the trenches 6. This cleaning process step increases the cleanness inside the via holes 5 and trenches 6 so much as to improve the adhesion of the plating coating to be formed in a subsequent process step.

Optionally, the surface of the conductor circuit 3 exposed at the bottom of the via holes 5 may be subjected to an activation process, which may be performed by immersing the substrate for 5-10 seconds in an acidic solution including a 10% solution of sulfuric acid or hydrochloric acid, for example. The immersion of the substrate in such an acidic solution may dissolve a thin oxide film, if any, by neutralizing an alkaline substance remaining on the surface of the conductor circuit 3 that is an activated region.

### <Catalyst Applying Process Step>

Next, as shown in FIG. 4(a), a catalyst 22 is applied onto the second resin layer 4, and thereby deposited onto the via holes 5 and trenches 6 of the second resin layer 4.

This process step may be performed using a catalyst solution including divalent palladium ions (Pd²⁺). In this case, the catalyst solution may be a mixture including palladium chloride (PdCl₂ · 2H₂O) with a Pd concentration of 100-300 mg/l, stannous chloride (SnCl₂ · 2H₂O) with an Sn concentration of 10-20 g/l, and 150-250 ml/l of hydrochloric acid (HCl).

To apply the catalyst 22, first, the substrate shown in FIG. 3(d) is immersed in the catalyst solution at a temperature of 30-40°C for one to three minutes, for example, thereby adsorbing a Pd-Sn colloid onto the surface of the substrate. Next, the substrate is immersed at an ordinary temperature in an accelerator (or promoter) of 50-100 ml/l of sulfuric acid or hydrochloric acid, thereby activating the catalyst. This activation process removes tin as a complex compound and turns it into palladium adsorbed particles, which ultimately serve as a palladium catalyst that promotes the deposition of the plating metal by the electroless plating process.

Alternatively, this process step may be performed with a catalyst solution including copper ions (Cu²⁺) used as the catalyst 22. Still alternatively, an acidic colloidal catalyst solution including no tin or an alkaline ionic catalyst solution may also be used. Moreover, a sodium hydroxide solution or an ammonia solution may be used as the accelerator as well.

Optionally, the substrate may be subjected to a pretreatment for enhancing adhesion between the second resin layer 4 and the metal layer 7 inside the via holes 5 and trenches 6 using a conditioner liquid or a pre-dip liquid. Alternatively, for example, the catalyst may also be applied to the substrate by bringing the substrate into contact with a sprayed catalyst solution.

### <Protective Layer Stripping Process Step>

Next, as shown in FIG. 4(b), the protective layer 8 is stripped from the surface 4a of the second resin layer 4 with a stripping solution. More specifically, the substrate to which the catalyst 22 has been applied as shown in FIG. 4(a) is immersed in a stripping solution, thereby dissolving the protective layer 8 in the stripping solution and stripping the protective layer 8 from the surface 4a of the second resin layer 4.

The stripping solution to use may be changed appropriately according to the type of the resin material of the protective layer 8 to be stripped. For example, if the protective layer 8 is made of a resin soluble in an alkaline aqueous solution of the polyimide resin or silicon resin described above, then an alkali metal hydroxide aqueous solution such as a sodium hydroxide aqueous solution or a potassium hydroxide aqueous solution may be used as the stripping solution. On the other hand, if the protective layer 8 is made of a resin soluble in an alcohol solution of the acrylic resin or phenol resin described above, for example, then an alcoholic solution such as isopropyl alcohol may be used as the stripping solution.

In this process step, the method of stripping the protective layer 8 by immersing the substrate (i.e., the protective layer 8) in the stripping solution is adopted to prevent the catalyst 22 deposited on the via holes 5 and trenches 6 from being removed and eventually prevent the plating metal from failing to be deposited during the plating process to be described below.

The duration of immersing the protective layer 8 in the stripping solution may be adjusted appropriately according to the resin material of the protective layer 8, the concentration of the stripping solution, or any other parameter. For example, if the protective layer 8 made of a polyimide resin is going to be stripped with a sodium hydroxide aqueous solution with a concentration of 0.4 mol/l, the duration of immersion may be set to fall within the range of 30 seconds to 120 seconds. Setting the duration of immersion in accordance with the concentration of the stripping solution to use in this manner enables stripping of the protective layer 8 while reliably preventing the catalyst 22 deposited on the via holes 5 and trenches 6 from being removed.

Optionally, a masking tape may be adhered, instead of the protective layer 8, onto the second resin layer 4 and then peeled off after the catalyst has been applied, in order to selectively deposit the catalyst 22 on only the via holes 5 and trenches 6 while preventing the catalyst 22 from being deposited outside of the trenches 6 or via holes 5.

### <Plating Process Step>

Next, the substrate to which the catalyst 22 has been applied as shown in FIG. 4(b) (i.e., the target substrate 30) is subjected to a plating process (i.e., an electroless plating process), thereby filling the via holes 5 and trenches 6, on which the catalyst 22 has been deposited, with the plating metal. In this manner, a metal layer 7 is formed which will constitute the circuitry of the printed wiring board 1.

The electroless plating solution for use in this process step includes, as a major ingredient, a water-soluble metal salt such as a water-soluble cupric (alloy) salt or a water-soluble nickel (alloy) salt, and further includes: one or more reducing agents such as formaldehyde or paraformaldehyde, glyoxylic acid or a salt thereof, hypophosphorous acid or a salt thereof, or dimethylamino borane; a complexing agent such as tetrasodium ethylenediamine tetraacetate or potassium sodium tartrate; and at least one sulfur-containing organic compound as a leveler.

Further, the electroless plating solution includes, as a major ingredient, a water-soluble metal salt such as a water-soluble cupric salt or a water-soluble nickel salt. Addition of a water-soluble cupric salt or a water-soluble nickel salt as the water-soluble metal salt produces an electroless copper plating solution or an electroless nickel plating solution, respectively.

As the water-soluble cupric salt, copper sulfate, copper chloride, copper nitrate, copper acetate, EDTA copper, or any other suitable copper salt may be used, for example. Any one of these water-soluble cupric salts may be added by itself, or two or more salts selected from this group may also be added in combination at any ratio. The water-soluble cupric salt suitably has a concentration of 0.001 mol/L to 0.2 mol/L. If copper is contained as a metal ion source, the water-soluble cupric salt does not have to be contained, but any other metal salt may be contained to produce an electroless copper alloy plating solution.

As the water-soluble nickel salt, an organic nickel salt such as nickel chloride, nickel sulfate, nickel nitrate, nickel acetate, or nickel hypophosphite may be used. Any one of these water-soluble nickel salts may be added by itself, or two or more salts selected from this group may also be added in combination at any ratio. The water-soluble nickel salt suitably has a concentration of 0.001 mol/L to 0.2 mol/L. If nickel is contained as a metal ion source, the water-soluble nickel salt does not have to be contained, but any other metal salt may be contained to produce an electroless nickel alloy plating solution.

The reducing agent may be a known reducing agent such as formaldehyde, paraformaldehyde, glyoxylic acid or a salt thereof, hypophosphorous acid or a salt thereof, or dimethylamino borane. Any one of these reducing agents may be added by itself, or two or more reducing agents selected from this group may also be added in combination at any ratio. The reducing agent suitably has a concentration of 0.01 mol/L to 0.5 mol/L.

As the complexing agent, polyamine, polyalkanolamine, polyamino polycarboxylic acid or a salt thereof, carboxylic acid or a salt thereof, oxycarboxylic acid or a salt thereof, amino acid or a salt thereof, or any other appropriate compound may be used. Any one of these complexing agents may be added by itself, or two or more complexing agents selected from this group may also be added in combination at any ratio. Addition of any of these complexing agents to the electroless plating solution allows the metal ions such as copper ions or nickel ions to be retained with stability even in the alkaline plating solution.

More specifically, examples of the polyamines include ethylenediamine, triethylenetetramine, hexamethylenetetramine, and pentaethylenehexamine. Examples of the polyalkanolamines include triethanolamine, diethanolamine, and triisopropanolamine. Examples of the polyamino polycarboxylic acids include ethylenediamine tetraacetic acid (EDTA), nitrilotriacetic acid, diethylenetriamine pentaacetic acid, and their salts. Examples of the oxycarboxylic acids include citric acid, tartaric acid, gluconic acid, malic acid, and their salts. Examples of the amino acids include glycine, glutamic acid, and their salts.

As the complexing agent contained in an electroless plating solution according to this embodiment, ethylenediamine tetraacetic acid tetrasodium (EDTA-4Na), sodium potassium tartaric acid (Rochelle salt), trisodium hydroxyethylethylenediamine triacetic acid (HEDTA) or any other appropriate compound may be used suitably. The complexing agents are suitably contained at a concentration of 0.01 mol/L to 1 mol/L such that the total molarity of the complexing agents is one to five times as high as that of the water-soluble metal salts.

The electroless plating solution used in the invention contains, as a leveler, at least one sulfur-containing organic compound, which at least one compound represented by any one of the following general Formulae (I) to (V):

R¹-(S)ₙ-R² (I)

R¹-L¹-(S)ₙ-R² (II)

R¹-L¹-(S)ₙ-L²-R² (III)

R¹-(S)ₙ-L³ (IV)

R¹-L¹-(S)ₙ-L³ (V)

where n is an integer equal to or greater than one; R¹ and R² independently represent an aliphatic or aromatic cyclic group including any arbitrary number of carbon atoms, oxygen atoms, phosphorus atoms, sulfur atoms, or nitrogen atoms, or a cyclic group in which one or more arbitrary substituents are bonded to the aliphatic or aromatic cyclic group; L¹ and L² independently represent a linear or branched one of a chain selected from the group consisting of an alkyl chain, an alkyl amino chain, an alkylene chain, and an alkoxy chain; and L³ is selected from the group consisting of an alkyl group, an alkylene group, an amino group, an alkyl amino group, an alkylene amino group, a hydroxyl group, an alkyl hydroxyl group, an alkylene hydroxyl group, a carboxyl group, an alkyl carboxyl group, an alkylene carboxyl group, an alkyl amino carboxyl group, an alkylene amino carboxyl group, a nitro group, an alkyl nitro group, a nitrile group, an alkyl nitrile group, an amide group, an alkyl amide group, a carbonyl group, an alkyl carbonyl group, a sulfonic group, an alkyl sulfonic group, a phosphonic group, an alkyl phosphonic group, a sulfanyl group, a sulfinyl group, and a thiocarbonyl group.

Examples of substituents for R¹ and R² in the general Formulae (I) to (V) include an alkyl group, an alkylene group, an amino group, an alkyl amino group, an alkylene amino group, a hydroxyl group, an alkyl hydroxyl group, an alkylene hydroxyl group, a carboxyl group, an alkyl carboxyl group, an alkylene carboxyl group, an alkyl amino carboxyl group, an alkylene amino carboxyl group, a nitro group, an alkyl nitro group, a nitrile group, an alkyl nitrile group, an amide group, an alkyl amide group, a carbonyl group, an alkyl carbonyl group, a sulfonic group, an alkyl sulfonic group, a phosphonic group, an alkyl phosphonic group, a sulfanyl group, a sulfinyl group, and a thiocarbonyl group.

Examples of the cyclic group include a phenyl group, a naphthyl group, a furfuryl group, a pyridyl group, a thiazolyl group, a benzothiazolyl group, a pyrimidyl group, an imidazolyl group, and a thiophenyl group.

Such a sulfur-containing organic compound is not particularly limited but may be, for example, 2,2'-dipyridyl disulfide, 2,2'-dibenzothiazolyl disulfide, 3,3',5,5'-tetrachlorodiphenyl disulfide, 2,2'-dithiobis(5-nitropyridine), 2,2'-dithio dibenzoic acid, 2,2'-dithio dianiline, 5,5'-dithiobis(2-nitro benzoic acid), 4,4'-bis(2-amino-6-methylpyrimidyl) disulfide, 4,4'-dipyridyl sulfide, 6,6'-dithio dinicotinic acid, 2,2'-dithio disalicylic acid, difurfuryl sulfide, bis(6-hydroxy-2-naphthyl) disulfide, furfuryl methyl disulfide, bis(2-benzamidephenyl) disulfide, bis(3-hydroxyphenyl) disulfide, diethyldithio carbamic acid 2-benzothiazolyl, 5,5'-thio disalicylic acid, 5,5'-dithio disalicylic acid, (4-pyridylthio) acetic acid, 3-(2-benzothiazolylthio) propionic acid, and 4-(2-benzothiazolylthio) morpholine. Among other things, 2,2'-dipyridyl disulfide, 6,6'-dithio dinicotinic acid, 2,2'-dithio dibenzoic acid, and bis(6-hydroxy-2-naphthyl) disulfide are suitably used, because each of these compounds allows the trenches and via holes to be more perfectly filled with the plating metal, may be used in a broader concentration range, less likely changes with time, and is less affected by decomposed products.

This sulfur-containing organic compound is suitably contained at a concentration in the range of 0.001 mg/L to 500 mg/L, more suitably in the range of 0.05 mg/L to 50 mg/L. If its concentration were too low, then the compound would be unable to perform its function as a leveler sufficiently effectively. However, if its concentration were too high, then the compound would function as a leveler too intrusively to avoid interfering with the deposition of the plating solution. In addition, the plating coating deposited on the surface of the substrate and inside the trenches and via holes would be too thin to fill the trenches and via holes with the plating metal sufficiently, which would result in a highly defective printed wiring board. For these reasons, the electroless plating solution according to this embodiment suitably includes the sulfur-containing organic compound at a concentration in the range of 0.05 mg/L to 50 mg/L. The sulfur-containing organic compound contained at such a concentration would function as a leveler sufficiently effectively and allow the trenches and via holes to be filled with the plating metal as intended.

Sulfur molecules of such a sulfur-containing organic compound have the properties of exhibiting strong interaction with a metal and adsorbing closely to the surface of the metal when in contact with the surface. This sulfur-containing organic compound will diffuse, along with metal ions, through the plating solution and be supplied into the catalyst. However, the compound is supplied less into the trenches and via holes, where the plating solution flows less rapidly, than onto the surface of the substrate. Thus, the closer to the bottom of the trenches or via holes, the less the sulfur-containing organic compound is supplied and the less significantly the electroless plating reaction is hampered. Consequently, so-called "bottom up deposition" progresses, thus enabling the trenches and other holes to be filled with the plating metal without causing voids or other defects inside those trenches or other holes.

In addition, the electroless plating solution including a sulfur-containing organic compound having a cyclic group used in the present invention allows the trenches and other holes to be filled with the plating metal sufficiently while reducing the occurrence of voids, seams, and other defects significantly for a long time.

More specifically, in the case of an electro less copper plating process, for example, the higher the pH of the plating solution is, the higher the reducing power of the reducing agent contained in the plating solution will be. For that reason, the pH of the electroless plating solution to use is suitably set to be in a highly alkaline range of 10 to 14. A conventional electroless plating solution with a pH falling within such a highly alkaline range stabilizes thiol anion and allows the disulfide bond to be cut off more easily, thus causing the sulfur-containing organic compound to lose its stability and decompose itself and preventing the compound from maintaining a stable state for a long time. The reason is that an electron-attracting group such as sulfone group or carboxyl group is introduced into the sulfur-containing organic compound used in the conventional electroless plating solution. Consequently, the conventional electroless plating solution cannot reduce the occurrence of voids, seams, and other defects for a long time.

In contrast, the electroless plating solution used in the present invention includes a sulfur-containing organic compound with a cyclic group serving as an electron-attracting group, thus allowing the disulfide bond to be cut off less easily and causing a self-decomposition reaction much less frequently even under a highly alkaline condition. Thus, the electroless plating solution may maintain stable state and performance for a long time and form a plating coating as intended without producing voids, seams or any other defects.

Moreover, addition of such a sulfur-containing organic compound with a highly adsorptive cyclic group causes the leveler's impact on the deposition rate to depend more heavily on the flow velocity, thus enhancing the leveler's effect. As a result, even large trenches or via holes may be filled with the plating metal more perfectly without producing any of those defects, and the resulting plating coating may have a smooth surface with no significant level differences.

The electroless plating solution used in the present invention may include not only a metal ion source such as the water-soluble cupric salt or water-soluble nickel salt described above, a reducing agent for the metal ions, a complexing agent for retaining the metal ion source with stability, and a sulfur-containing organic compound for use as a leveler, but also a surfactant, a plating deposition promoter, and other agents as well. The electroless plating solution may further include an additive such as a stabilizer/coating property improving agent. Specific examples of these compounds will be given below. Note, however, that the compounds contained in the electroless plating solution used in the present invention are not limited to the ones enumerated below.

Examples of the surfactant include polyoxyalkylene glycols, alkyl ethers, polyoxyalkylene glycol copolymers, and polyoxyalkylene glycol alkyl ether copolymers. The surfactant may include at least one of these compounds, or two or more compounds selected from this group in combination at an arbitrary ratio. This surfactant suitably has a concentration in the range of 0.1 mg/L to 10000 mg/L.

The surfactant has the advantage of allowing the hydrogen gas produced as a result of the reaction to leave the trenches or via holes more easily. In addition, the surfactant also has the following advantages:

Specifically, the sulfur-containing organic compound contained in the electroless plating solution of this embodiment tends to have molecules aggregated together in the plating solution, thus making uneven the surface of the plating coating formed by the plating process and producing air gaps such as voids inside the trenches and via holes to cause filling failures. Thus, addition of any of the above-enumerated compounds as a surfactant or other suitable agent to the plating solution would promote the dispersion of the sulfur-containing organic compound molecules and reduce the occurrence of voids, seams, and other defects inside the trenches or via holes.

As the plating deposition promoter, polyamine, polyalkanolamine, polyamino polycarboxylic acid or a salt thereof, a chloride ion, a nitric acid ion, 8-hydroxy-7-iodo-5-quinoline sulfonic acid, or any other suitable substance may be used. Any one of these promoters may be added by itself, or two or more promoters selected from this group may also be added in combination at any ratio.

More specifically, examples of the polyamine include ethylenediamine, triethylenetetramine, hexamethylenetetramine, and pentaethylenehexamine. Also, as the polyalkanolamine, triethanolamine, diethanolamine, triisopropanolamine, or any other appropriate amine may be used. As the polyamino polycarboxylic acid, ethylenediamine tetraacetic acid (EDTA), nitrile triacetic acid, diethylenetriamine pentaacetic acid, or any other appropriate compound may be used. Addition of any of these deposition promoters of these plating metals promotes the plating growth effect from the bottom of those trenches or via holes (bottom-up effect) and allows efficient formation of a plating coating with no defects such as voids or seams at a sufficiently high plating rate.

The electroless plating solution used in the present invention may further include an additive such as a stabilizer/coating property improving agent. As the stabilizer/coating property improving agent, any one of known compounds such as 2,2'-bipyridyl and 1,10-phenanthroline may be added, or any two or more selected from the group may be added in combination at an arbitrary ratio.

Optionally, the plating solution 20 may further include a surfactant, a plating deposition promoter, or any other appropriate agent as needed. Further, the plating solution 20 may further include any known stabilizer/coating property improving agent such as 2,2'-bipyridyl or 1,10-phenanthroline.

The plating process time is not particularly limited but may be adjusted appropriately according to the sizes of the via holes 5 and trenches 6 or any other parameter. The substrate to which the catalyst has been applied may be immersed in the plating solution 20 for 30 to 60 minutes, for example.

The plating process temperature is not particularly limited as long as reduction reaction of metal ions such as copper ions is producible at the temperature. However, to produce the reduction reaction efficiently, the temperature of the plating solution 20 is suitably set in the range of 20-90°C, more suitably in the range of 50-70°C.

Further, pH of the plating solution 20 is not particularly limited, but is suitably set in the range of 10-14. Setting the pH of the plating solution 20 in such a highly alkaline range allows the reduction reaction of metal ions such as copper ions to progress efficiently, thus improving the deposition rate of the metal plating coating. Note that in order to maintain the pH of the plating solution 20 in the range of 10-14, the plating solution 20 may include a pH adjustor such as sodium hydroxide, potassium hydroxide, or tetramethylammonium hydroxide. Any of these pH adjustors may be added, after having been diluted with water if necessary, to the plating solution 20.

Also, while the electroless plating process is being carried out, the plating solution 20 is suitably stirred up well enough to supply sufficient ions to the via holes 5 and trenches 6. As the method of stirring up the plating solution 20, a technique using pneumatic agitation or pump circulation may be adopted, for example.

Besides, according to this embodiment, such an electroless plating process is carried out with the electroless plating system 10 described above, thereby connecting the metal layer 7 covering the via holes 5 to the conductor circuit 3 via the via holes 5 and forming a wiring pattern out of the metal layer 7 filling the trenches 6. As a result, the printed wiring board 1 shown in FIG. 1 is completed.

In this case, according to this embodiment, the system is configured as described above to make the plating solution supply means 12 supply the plating solution 20 to under the target substrate 30 and also make the diffusion means 13 diffuse the oxygen-containing gas into the plating solution 20 that has been supplied to under the target substrate 30. In addition, the overflow tank 14 is arranged at the top of the plating tank 11 so as to allow the plating solution 20 in the plating tank 11 to overflow from over the target substrate 30.

Thus, a more rapid rising liquid current of the plating solution 20 produced inside the plating tank 11 allows the air bubbles in the plating solution 20 (i.e., the oxygen-containing gas) to be uniformly dispersed over the entire surface of the target substrate 30, which results in an increase in the concentration of oxygen dissolved on the surface of the target substrate 30. This produces an oxidizing atmosphere inside the plating tank 11 (i.e., the plating bath), thus preventing the plating solution from being deposited abnormally outside of the trenches 6 and via holes 5 of the target substrate 30. Consequently, disconnection and short circuit of the conductor circuit 3, which would otherwise be caused by the anomalous deposition of the excess of the plated metal, and other inconveniences may be reduced significantly.

Moreover, air bubbles do not enter the trenches 6 or via holes 5 easily, and therefore, the plated metal comes to have only a small number of air bubbles (i.e., the concentration of dissolved oxygen is low), thus producing a reducing atmosphere. This promotes the plating reaction to the point that the trenches 6 and via holes 5 are filled with the plating metal sufficiently.

### (Second Embodiment)

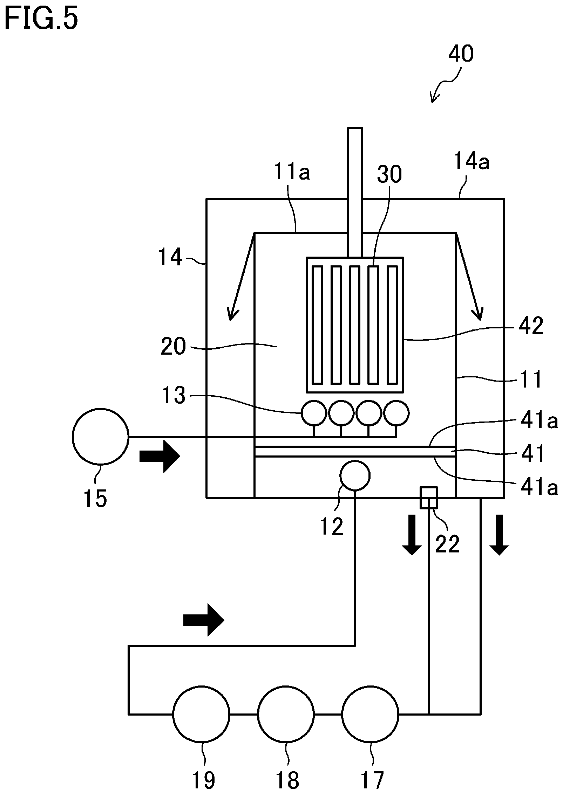

Next, a second embodiment of the present invention will be described. Any constituent of the second embodiment corresponding to its counterpart of the first embodiment will be identified by the counterpart's reference numeral, and description thereof will be omitted herein. A wiring board fabricated according to the second embodiment is fabricated by the same method as in the first embodiment described above, and will not be described in detail all over again. FIG. 5 illustrates an electroless plating system used in the second embodiment of the present invention.

The electroless plating system 40 used in this embodiment further includes a rectifier means 41 for rectifying the flow of the plating solution 20 in the plating tank 11 as shown in FIG. 5.

This rectifier means 41 is provided in the plating tank 11 so as to be located between the diffusion means 13 arranged under the target substrate 30 and the liquid supply means 12 arranged at the bottom of the plating tank 11 as shown in FIG. 5. That is to say, according to this embodiment, the liquid supply means 12, rectifier means 41, diffusion means 13, and target substrate 30 are vertically arranged in this order from the bottom of the plating tank 11 toward the top. Also, the liquid supply means 12 is configured as a single horizontally arranged tubular member.

As this rectifier means 41, a plate member with a number of holes allowing the plating solution 20 to pass through may be used, for example. In this embodiment, the horizontal surface 41a of the rectifier means 41 has its size defined to partition the inside of the plating tank 11 with no gaps left.

According to this embodiment, providing such a rectifier means 41 allows the plating solution 20 to flow at a constant flow rate and/or flow velocity anywhere inside the plating tank 11, thus having the air bubbles in the plating solution 20 distributed even more uniformly over the entire surface of the target substrate 30 and further increasing the concentration of dissolved oxygen on the surface of the target substrate 30. This more reliably prevents the plating solution from being deposited abnormally outside of the trenches 6 and via holes 5 of the target substrate 30.

In addition, this rectifier means 41 allows the plating solution 20 to flow at a constant flow rate and/or flow velocity inside the plating tank 11, thus enabling the plating solution 20 to have a uniform pressure. This may prevent the target substrate 30 from rocking and getting damaged in a region where the plating solution 20 has a high pressure.

In this embodiment, the overflow tank 14, as well as the plating tank 11, is a generally rectangular parallelepiped container with a substantially rectangular opening 14a at the top, and is configured to house the plating tank 11 in its entirety inside. In this embodiment, the plating tank 11 does not have the outlets 11b described for the first embodiment, and the system used in this embodiment is configured such that the plating solution 20 is allowed to overflow through the opening 11a of the plating tank 11 into the overflow tank 14 and stored inside the overflow tank 14.

Furthermore, as shown in FIG. 5, the diffusion means 13 is implemented as four tubular members made of a porous ceramic material. These four tubular members are arranged parallel to each other, and configured to supply the oxygen-containing gas at a sufficiently high rate onto the surface of the target substrates 30.

Furthermore, in this embodiment, the jig 21 described above is replaced with a supporting member 42 in which a plurality of target substrates 30 may be housed while being supported. This supporting member 42 may be a generally rectangular parallelepiped container with an internal space that can house five target substrates 30 in a substantially perpendicular position, for example, as shown in FIG. 5, and has guide grooves (not shown) to which the respective target substrates 30 are inserted. The supporting member 42 is configured to support those target substrates 30 substantially parallel to each other. Note that the supporting member 42 is connected to a transporter (not shown) and is movable both vertically and horizontally inside and outside the plating tank 11.

### EXAMPLES

The present invention will now be described by way of illustrative examples. Note that the present invention is in no way limited to any of these specific examples, which may rather be readily modified or varied without departing from the scope of the present invention. Stated otherwise, all of those modifications and variations do fall within the scope of the present invention.

### (First Example)

A substrate, on which a general electrically insulating resin (trade name: ABF-GX13 manufactured by Ajinomoto Fine-Techno Co., Inc.) had been deposited and which had then been coated with a photoresist (as a protective layer), was subjected to a machining process with a laser cutting machine (trade name: LC-L manufactured by Hitachi Via Mechanics, Ltd.) for use to cut via holes while being selectively masked with the photoresist pattern, thereby cutting trenches with a width of 10 µm and a depth of 10 µm as a circuit.

Then, a catalyst (as a seed layer) was applied by catalyst application process (through-cup process using a cleaner conditioner ACL-009, a pre-dip PED-104, a catalyst AT-105, and an accelerator AL-106, all manufactured by Uyemura & Co., Ltd.), and the photoresist was stripped with a sodium hydroxide aqueous solution.

Thereafter, an electro less plating process was carried out at a temperature of 70°C for two hours with an electroless copper plating solution, which had been prepared to have the following composition, supplied by the plating solution supply means in the electroless plating system of the first embodiment, and with an oxygen-containing gas diffused. The oxygen-containing gas was allowed to diffuse with the oxygen-containing gas supplied at a rate of 0.2 L/min per liter of the plating solution. Before the electroless plating process was started, the oxygen-containing gas stopped being diffused for two minutes.

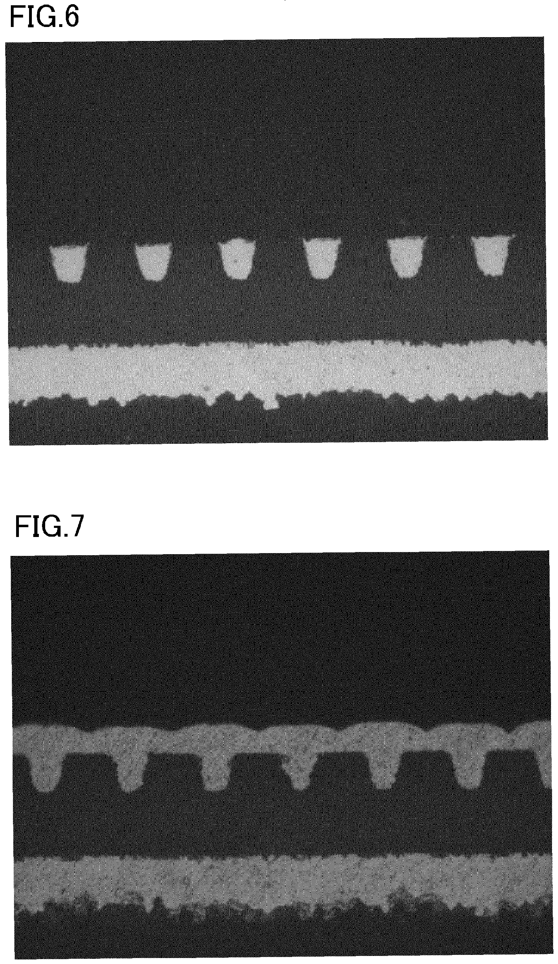

After the plating process was over, a cross section of the trenches was observed through a metallurgical microscope to see whether or not the plating solution had been deposited outside the trenches and to evaluate the degree of fillability (loadability) of the trenches with the metal layer. The fillability of the trenches with the metal layer was rated "good" when no voids or seams were observed on the cross section. The results thus collected are summarized in Table 1 and the metallographic micrograph thus captured is shown in FIG. 6.

### <Composition of Electroless Copper Plating Solution (First Example)>

Copper sulfate: 0.04 mol/L
EDTA: 0.1 mol/L
Sodium hydroxide: 4g/L
Formaldehyde: 4 g/L
2,2'-bipyridyl: 2 mg/L
Polyethylene glycol (with a molecular weight of 1000): 1000 mg/L
2,2'-dipyridyl disulfide: 5 mg/L

### (Second Example)

A substrate, on which a general electrically insulating resin (trade name: ABF-GX13 manufactured by Ajinomoto Fine-Techno Co., Inc.) had been deposited and to which a masking tape had then been adhered as a protective layer, was subjected to a machining process with a laser cutting machine (trade name: LC-L manufactured by Hitachi Via Mechanics, Ltd.) for use to cut via holes while being selectively masked with the masking tape, thereby cutting trenches with a width of 10 µm and a depth of 10 µm as a circuit.

Then, a catalyst (as a seed layer) was applied by catalyst application process (through-cup process using a cleaner conditioner ACL-009, a pre-dip PED-104, a catalyst AT-105, and an accelerator AL-106 all manufactured by Uyemura & Co., Ltd.), and the making tape was stripped.

Thereafter, an electroless plating process was carried out at a temperature of 70°C for two hours with an electroless copper plating solution, which was also used in the first example, supplied by the plating solution supply means in the electroless plating system of the second embodiment, and with an oxygen-containing gas diffused. The oxygen-containing gas was allowed to diffuse with the gas supplied at a rate of 0.6 L/min per liter of the plating solution. Before the electroless plating process was started, the oxygen-containing gas stopped being diffused for two minutes.

After the plating process was over, a cross section of the trenches was observed to see whether or not the plating solution had been deposited outside the trenches and to evaluate the degree of fillability (loadability) of the trenches with the metal layer. The results thus collected are summarized in Table 1.

### (Third Example)

An electroless plating process was carried out in the same way as in the first example described above except that the oxygen-containing gas was allowed to diffuse into the plating solution at a rate of 0.9 L/min per liter of the plating solution. Thereafter, a cross section of the trenches was observed as in the first example to see whether or not the plating solution had been deposited outside the trenches and to evaluate the degree of fillability (loadability) of the trenches with the metal layer. The results thus collected are summarized in Table 1.

### (First Comparative Example)

An electroless plating process was carried out in the same way as in the first example described above except that no oxygen-containing gas was allowed to diffuse during the electroless plating process. Thereafter, a cross section of the trenches was observed as in the first example to see whether or not the plating solution had been deposited outside the trenches and to evaluate the degree of fillability (loadability) of the trenches with the metal layer. The results thus collected are summarized in Table 1.

### (Second Comparative Example)

An electroless plating process was carried out in the same way as in the second example described above except that an electroless plating solution prepared to have the following composition was used and the oxygen-containing gas was allowed to diffuse at a rate of 0.2 L/min per liter of the plating solution. Thereafter, a cross section of the trenches was observed as in the first example to see whether or not the plating solution had been deposited outside the trenches and to evaluate the degree of fillability (loadability) of the trenches with the metal layer. The results thus collected are summarized in Table 1 and the metallographic micrograph thus captured is shown in FIG. 7.

### <Composition of Electroless Copper Plating Solution (Second Comparative Example)>

Copper sulfate: 0.04 mol/L
EDTA: 0.1 mol/L
Sodium hydroxide: 4 g/L
Formaldehyde: 4 g/L
Polyethylene glycol (with a molecular weight of 1000): 1000 mg/L

**[Table 1]**

| | Loadability | Any plating solution deposited outside trenches? |
|---|---|---|
| Example 1 | Good | NO |
| Example 2 | Good | NO |
| Example 3 | Good | ²NO |
| Cmp. Ex. 1 | Good | YES |
| Cmp. Ex. 2 | Bad | NO |

As can be seen from this Table 1, it was confirmed that no plating solution was deposited in the first to third examples on the surface outside the trenches and the trenches were sufficiently filled with the metal layer, unlike the first and second comparative examples.

These results revealed that the methods of the first to third examples could reliably prevent the plating solution from being deposited abnormally on the surface outside the trenches.

### INDUSTRIAL APPLICABILITY

As can be seen from the foregoing description, the present invention is effectively applicable to a method for fabricating a wiring board through a plating process.

### DESCRIPTION OF REFERENCE CHARACTERS

- 1: Printed Wiring Board
- 2: First Resin Layer
- 3: Conductor Circuit
- 4: Second Resin Layer
- 4a: Surface of Second Resin Layer
- 5: Via Hole
- 6: Trench
- 7: Metal Layer
- 8: Protective Layer
- 9: Through Hole
- 10: Electroless Plating System
- 11: Plating Tank
- 12: Liquid Supply Means
- 13: Diffusion Means
- 14: Overflow Tank
- 18: Temperature Adjustment Means
- 20: Plating Solution
- 23: Discharge Passage
- 24: Discharge Port
- 30: Target Substrate
- 40: Electroless Plating System
- 41: Rectifier Means
- 42: Supporting Means

## Claims

1. A method for fabricating a wiring board in which a target substrate having via holes and/or trenches is subjected to an electroless plating process while being immersed in an electroless plating solution to fill the via holes and/or the trenches with a plating metal, the method comprising the steps of:
supplying the electroless plating solution to under the target substrate;
diffusing an oxygen-containing gas into the electroless plating solution supplied under the target substrate; and
allowing the electroless plating solution to overflow from over the target substrate,
the diffusion of the oxygen-containing gas being temporarily suspended for a predetermined amount of time before the target substrate is completely immersed in the electroless plating solution, wherein
the electroless plating solution includes at least a water-soluble metal salt, a reducing agent, and a complexing agent, and also includes a leveler comprised of at least one sulfur-containing organic compound represented by any one of the following general Formulae (I)-(V):
R¹-(S)ₙ-R² (I)
R¹- L¹-(S)ₙ-R² (II)
R¹-L¹-(S)ₙ-L²-R² (III)
R¹-(S)ₙ-L³ (IV)
R¹-L¹-(S)ₙ-L³ (V)
where n is an integer equal to or greater than one; R¹ and R² independently represent an aliphatic or aromatic cyclic group including any arbitrary number of carbon atoms, oxygen atoms, phosphorus atoms, sulfur atoms, or nitrogen atoms, or a cyclic group in which one or more arbitrary substituents are bonded to the aliphatic or aromatic cyclic group;
L¹ and L² independently represent a linear or branched one of a chain selected from the group consisting of an alkyl chain, an alkyl amino chain, an alkylene chain, and an alkoxy chain, and
L³ is selected from the group consisting of an alkyl group, an alkylene group, an amino group, an alkyl amino group, an alkylene amino group, a hydroxyl group, an alkyl hydroxyl group, an alkylene hydroxyl group, a carboxyl group, an alkyl carboxyl group, an alkylene carboxyl group, an alkyl amino carboxyl group, an alkylene amino carboxyl group, a nitro group, an alkyl nitro group, a nitrile group, an alkyl nitrile group, an amide group, an alkyl amide group, a carbonyl group, an alkyl carbonyl group, a sulfonic group, an alkyl sulfonic group, a phosphonic group, an alkyl phosphonic group, a sulfanyl group, a sulfinyl group, and a thiocarbonyl group.

2. The method of claim 1, wherein the oxygen-containing gas has an air bubble size of 5 µm to 50 µm.

3. The method of claim 1 or 2, wherein the electroless plating process is performed by an electroless plating system comprising: a plating tank filled with the electroless plating solution; a plating solution supply means for supplying the electroless plating solution to under the target substrate; a diffusion means for diffusing an oxygen-containing gas into the electroless plating solution; and an overflow tank allowing the electroless plating solution to overflow from over the target substrate.

4. The method of claim 3, wherein the diffusion means is made of a porous ceramic material.

5. The method of claim 3 or 4, wherein the electroless plating system includes a rectifier means for rectifying a flow of the electroless plating solution in the plating tank.

## Patentansprüche

1. Verfahren zur Herstellung einer Leiterplatte, in dem ein Zielsubstrat, das Durchgangslöcher und/oder Gräben aufweist, einem stromlosen Plattierungsvorgang unterzogen wird, während es in eine stromlose Plattierungslösung eingetaucht ist, um die Durchgangslöcher und/oder die Gräben mit einem Plattierungsmetall zu füllen, wobei das Verfahren die folgenden Schritte umfasst:
Zuführen der stromlosen Plattierungslösung unter das Zielsubstrat;
Diffundieren eines sauerstoffhaltigen Gases in die stromlose Plattierungslösung, die unter das Zielsubstrat zugeführt wurde; und
Überlaufenlassen der stromlosen Plattierungslösung über das Zielsubstrat,
wobei die Diffusion des sauerstoffhaltigen Gases für einen vorbestimmten Zeitraum vorübergehend unterbrochen wird, bevor das Zielsubstrat vollständig in die stromlose Plattierungslösung eingetaucht ist, wobei
die stromlose Plattierungslösung mindestens ein wasserlösliches Metallsalz, ein Reduktionsmittel und einen Komplexbildner enthält und außerdem einen Grundeinebner enthält, der aus mindestens einer schwefelhaltigen organischen Verbindung besteht, die durch eine beliebige der folgenden allgemeinen Formeln (I)-(V) dargestellt wird:
R¹-(S)ₙ-R² (I)
R¹-L¹-(S)ₙ-R² (II)
R¹-L¹-(S)ₙ-L²-R² (III)
R¹-(S)ₙ-L³ (IV)
R¹-L¹-(S)n-L³ (V),
wobei n eine ganze Zahl ist, die größer gleich eins ist; R¹ und R² unabhängig eine aliphatische oder aromatische cyclische Gruppe, die eine willkürliche Anzahl von Kohlenstoffatomen, Sauerstoffatomen, Phosphoratomen, Schwefelatomen oder Stickstoffatomen enthält, oder eine cyclische Gruppe, in der ein oder mehrere willkürliche Substituenten an die aliphatische oder aromatische cyclische Gruppe gebunden sind, darstellen;
L¹ und L² unabhängig eine lineare oder verzweigte von einer Kette darstellen, die aus der Gruppe bestehend aus einer Alkylkette, einer Alkylaminokette, einer Alkylenkette und einer Alkoxykette ausgewählt ist, und
L³ aus der Gruppe bestehend aus einer Alkylgruppe, einer Alkylengruppe, einer Aminogruppe, einer Alkylaminogruppe, einer Alkylenaminogruppe, einer Hydroxylgruppe, einer Alkylhydroxylgruppe, einer Alkylenhydroxylgruppe, einer Carboxylgruppe, einer Alkylcarboxylgruppe, einer Alkylencarboxylgruppe, einer Alkylaminocarboxylgruppe, einer Alkylenaminocarboxylgruppe, einer Nitrogruppe, einer Alkylnitrogruppe, einer Nitrilgruppe, einer Alkylnitrilgruppe, einer Amidgruppe, einer Alkylamidgruppe, einer Carbonylgruppe, einer Alkylcarbonylgruppe, einer Sulfonsäuregruppe, einer Alkylsulfonsäuregruppe, einer Phosphonsäuregruppe, einer Alkylphosphonsäuregruppe, einer Sulfanylgruppe, einer Sulfinylgruppe und einer Thiocarbonylgruppe ausgewählt ist.

2. Verfahren nach Anspruch 1, wobei das sauerstoffhaltige Gas eine Luftblasengröße von 5 µm bis 50 µm aufweist.

3. Verfahren nach Anspruch 1 oder 2, wobei der stromlose Plattierungsvorgang durch ein stromloses Plattierungssystem durchgeführt wird, umfassend: einen Plattierungstank, der mit der stromlosen Plattierungslösung gefüllt ist; ein Plattierungslösungszuführungsmittel zum Zuführen der stromlosen Plattierungslösung unter das Zielsubstrat; ein Diffusionsmittel zum Diffundieren eines sauerstoffhaltigen Gases in die stromlose Plattierungslösung; und einen Überlauftank zum Überlaufenlassen der stromlosen Plattierungslösung über das Zielsubstrat.

4. Verfahren nach Anspruch 3, wobei das Diffusionsmittel aus einem porösen Keramikmaterial hergestellt ist.

5. Verfahren nach Anspruch 3 oder 4, wobei das stromlose Plattierungssystem ein Berichtigermittel zum Berichtigen eines Flusses der stromlosen Plattierungslösung in dem Plattierungstank enthält.

## Revendications

1. Procédé de fabrication d'un tableau de connexions dans lequel un substrat cible ayant des trous d'interconnexion et/ou des tranchées est soumis à un procédé de dépôt autocatalytique tout en étant immergé dans une solution de dépôt autocatalytique pour remplir les trous d'interconnexion et/ou les tranchées d'un métal de dépôt, le procédé comprenant les étapes consistant :
à fournir la solution de dépôt autocatalytique sous le substrat cible ;
à diffuser un gaz contenant de l'oxygène dans la solution de dépôt autocatalytique fournie sous le substrat cible ; et
à permettre à la solution de dépôt autocatalytique de déborder du substrat cible,
la diffusion du gaz contenant de l'oxygène étant suspendue temporairement pendant une durée prédéterminée avant que le substrat cible ne soit complètement immergé dans la solution de dépôt autocatalytique, où
la solution de dépôt autocatalytique comporte au moins un sel métallique hydrosoluble, un agent réducteur et un agent complexant, et comporte également un agent de nivellement constitué d'au moins un composé organique contenant du soufre représenté par l'une quelconque des formules générales (I) à (V) suivantes :
R¹-(S)ₙ-R² (I)
R¹-L¹-(S)ₙ-R² (II)
R¹-L¹-(S)ₙ-L²-R² (III)
R¹-(S)ₙ-L³ (IV)
R¹-L¹-(S)ₙ-L³ (V)
où n est un nombre entier supérieur ou égal à un ; R¹ et R² représentent indépendamment un groupe cyclique aliphatique ou aromatique comportant un nombre arbitraire d'atomes de carbone, d'atomes d'oxygène, d'atomes de phosphore, d'atomes de soufre ou d'atomes d'azote, ou un groupe cyclique dans lequel un ou plusieurs substituant(s) arbitraire(s) est/sont lié(s) au groupe cyclique aliphatique ou aromatique ;
L¹ et L² représentent indépendamment une chaîne linéaire ou ramifiée choisie dans le groupe constitué par une chaîne alkyle, une chaîne alkylamino, une chaîne alkylène et une chaîne alcoxy, et
L³ est choisie dans le groupe constitué par un groupe alkyle, un groupe alkylène, un groupe amino, un groupe alkyl-amino, un groupe alkylène-amino, un groupe hydroxyle, un groupe alkyl-hydroxyle, un groupe alkylène-hydroxyle, un groupe carboxyle, un groupe alkyl-carboxyle, un groupe alkylène-carboxyle, un groupe alkyl-amino-carboxyle, un groupe alkylène-amino-carboxyle, un groupe nitro, un groupe alkyl-nitro, un groupe nitrile, un groupe alkyl-nitrile, un groupe amide, un groupe alkyl-amide, un groupe carbonyle, un groupe alkyl-carbonyle, un groupe sulfonique, un groupe alkyl-sulfonique, un groupe phosphonique, un groupe alkyl-phosphonique, un groupe sulfanyle, un groupe sulfinyle et un groupe thiocarbonyle.

2. Procédé de la revendication 1, dans lequel le gaz contenant de l'oxygène a une taille de bulles d'air allant de 5 µm à 50 µm.

3. Procédé de la revendication 1 ou 2, dans lequel le procédé de dépôt autocatalytique est effectué par un système de dépôt autocatalytique comprenant : un réservoir de dépôt rempli de la solution de dépôt autocatalytique ; un moyen d'alimentation en solution de dépôt pour fournir la solution de dépôt autocatalytique sous le substrat cible ; un moyen de diffusion pour diffuser un gaz contenant de l'oxygène dans la solution de dépôt autocatalytique ; et un réservoir de trop-plein permettant à la solution de dépôt autocatalytique de déborder du substrat cible.

4. Procédé de la revendication 3, dans lequel le moyen de diffusion est réalisé en un matériau céramique poreux.

5. Procédé de la revendication 3 ou 4, dans lequel le système de dépôt autocatalytique électrique comporte un moyen de rectification pour rectifier un écoulement de la solution de dépôt autocatalytique dans le réservoir de dépôt.
